# EUROPEAN PATENT APPLICATION

(11) **EP 1 895 229 A1**
(43) Date of publication of application: **05.03.2008**
(21) Application number: 06757128.1
(22) Date of filing: 07.06.2006
(51) Int. Cl.: F21V 8/00, F21V 19/00, F21V 29/00, G02B 6/00, G02F 1/13357, F21Y 101/02

(54) **SURFACE ILLUMINATOR**

(30) Priority: 08.06.2005 JP 2005168429
(71) Applicant: MINEBEA Co., Ltd., Kitasaku-gun, Nagano-Ken 389-0293 (JP)
(72) Inventor: SATOH, makoto c/o Minebea Co., Ltd., Kitasaku-gun, Nagano 3890293 (JP); OHNO, yasuo c/o Minebea Co., Ltd., Kitasaku-gun, Nagano 3890293 (JP)
(74) Representative: Steinegger, Peter
(86) International application number: PCT/JP2006/311421
(87) International publication number: WO 2006/132271

(57) **Abstract**

[PROBLEMS] To promote thinning of a surface illuminator while realizing higher and more uniform luminance by dissipating heat from a point light source more efficiently. [MEANS FOR SOLVING PROBLEMS] A heat dissipation path is constituted to transmit heat generated from a point light source (3) to a metallic heat dissipation plate (5a) through an electrode terminal (3a) of the point light source (3), a land portion (12) on the front surface (10F) of an FPC (10), a through hole (16) of a conductor pattern (14) and a high heat conduction resin (18). The path for efficiently dissipating heat from the conductor pattern (14) of the FPC (10) to the metallic heat dissipation plate (5a) is widened and a direct heat dissipation area is also secured sufficiently. Especially, even when a large current LED is employed in the point light source (3), sufficient heat dissipation effect can be attained. Since the degree of freedom of the wiring pattern and outline of the FPC (10) is not different from that of conventional FPCs, the request for thinning the surface illuminator can be met sufficiently.

## Description

### Technical Field

The present invention relates to a side-light-type planar illumination device and particularly to a planar illumination device used as illuminating means of a liquid crystal display device.

### Background Art

As an auxiliary light source for a liquid crystal display device used for a cellular phone or the like, a side-light type planar illumination device in which a primary light source is arranged on a side end face of a light guide plate is mainly used (hereinafter the side end face on which the primary light source is arranged is also called as an incoming-light face). As the primary light source of a side-light-type planar illumination device, a cold-cathode tube lamp has been used, but currently, a point-like light source such as a white LED which is more excellent in handling, easier in size reduction and better in impact resistance than the cold-cathode tube lamp is used in many cases. Application fields of the planar illumination device using such a point-like light source tend to expand, and application not only as a small-sized liquid crystal display device used in a cellular phone or the like but also as an auxiliary light source of a liquid crystal display device used in an in-vehicle navigator with a relatively large display size, for example, is being discussed.

In order to respond to the expansion of an illumination area, it is preferable to increase an electric current to be supplied to the point-like light source so as to increase an outgoing light amount per point-like light source. However, when the electric current supplied to the point-like light source is increased, a heat amount generated with light emission is also increased and there is a problem that light emitting efficiency of the point-like light source is lowered by temperature rise by the heat generation.

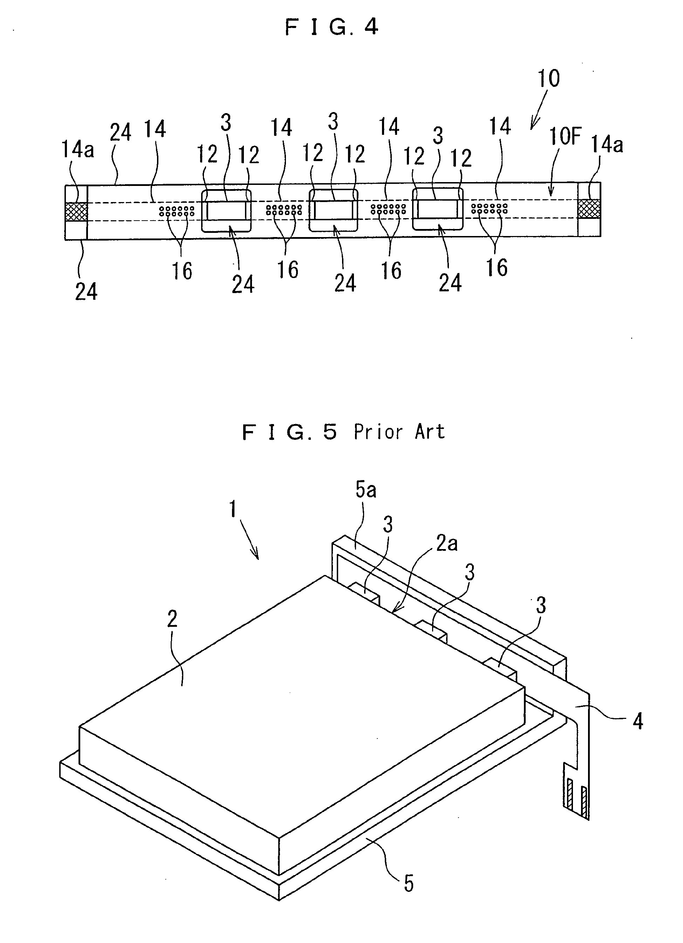

Therefore, various methods are examined to effectively let go the heat generated from the point-like light source to the outside, and as a planar illumination device 1 shown in Fig. 5, for example, in a planar illumination device having a light guide plate 2, a point-like light source 3 mounted on a flexible print circuit board (hereinafter also referred to as FPC) 4, and a frame 5 integrally holding them, use of a metal material with excellent heat conductance such as aluminum in a material constituting the frame 5 is proposed. Also, as means to let go the heat to the outside more efficiently, a radiator device for a point-like light source configured such that a through hole is formed on the FPC 4 and a radiator plate 5a made of metal on its back face and an adhesive filler agent with high heat conductance is filled in the through hole is proposed (See Patent Document 1, for example). In this radiator device, radiation characteristic is improved by connecting a bottom face, which is a package face closest to a light emitting portion to be a heat generating center of the point-like light source and a light-source supporting frame made of a metal material by an adhesive filler agent with heat conductance higher than that of FPC.
Patent Document 1: Japanese Unexamined Patent Application Publication No. 2002-162626

### Disclosure of Invention

However, according to the conventional radiation structure, the heat of the point-like light source is mainly transmitted to a conductor of the FPC and radiated from the conductor further through a cover film of the FPC, and a radiation path for efficient radiation from the conductor of the FPC is not sufficient and a direct radiation area is not enough. Particularly when a large-current type LED is used as the point-like light source, a radiation amount from the LED package is also increased, and the problem becomes more remarkable.

On the other hand, it is possible to improve the radiation characteristic by using a circuit board constructed by a material with high heat conductance such as aluminum, copper or the like, but with this method, there is a problem that there are many restrictions on wiring patterns and outlines and many nonconformities are encountered in thinning of the planar illumination device. In the case of the radiator device disclosed in Patent Document 1, though the radiation performance is excellent, a process for forming through holes both on a film substrate and a light-source supporting frame using a press machine, a process for filling an adhesive filler agent by a squeegee in the through hole, and a process for drying and solidifying the adhesive filler agent are needed, and a cost rise with procurement of new facilities and increase of manufacturing processes have been concerned.

The present invention was made in view of the above problems and has an object to enable more efficient radiation of heat from a point-like light source in a planar illumination device using the point-like light source and to promote thinning while accelerating higher and more uniform brightness of the planar illumination device.

A planar illumination device according to the present invention in order to solve the above problems, comprising a light guide plate, a point-like light source arranged on a side end face of the light guide plate, and a print circuit board in which the point-like light source is mounted on a front side face, is characterized in that a through hole is formed on a conductor pattern continuing to a land portion in the print circuit board where the point-like light source is mounted and a region on a back side face of the print circuit board where at least the through hole is formed is bonded to a radiator plate through a high heat-conductive resin.

According to the present invention, a radiation path is constituted through which heat generated from the point-like light source is transmitted to the radiator plate through an electrode terminal of the point-like light source, the land portion on the front side face of the print circuit board, the through hole on the conductor pattern and the high heat-conductive resin.

Also, in the present invention, a conductor pattern continuing to a plating film applied to the through hole is preferably formed in a region of the back side face of the print circuit board where at least the through hole is formed.

According to this configuration, a radiation path is constituted through which heat generated from the point-like light source is transmitted to the radiator plate through an electrode terminal of the point-like light source, the land portion on the front side face of the print circuit board, the plating film on the through hole on the conductor pattern, the conductor pattern on the back side face of the print circuit board, and the high heat-conductive resin.

Also, in the present invention, the high heat-conductive resin preferably has fluidity at least when being applied between the back side face of the print circuit board and the radiator plate and is filled in the through hole.

According to this configuration, a radiation path is constituted through which heat generated from the point-like light source is transmitted to the radiator plate through an electrode terminal of the point-like light source, the land portion on the front side face of the print circuit board, the plating film and the high heat-conductive resin in the through hole on the conductor pattern, and the high heat-conductive resin as well as the high heat-conductive resin applied between the back side face of the print circuit board and the radiator plate.

Also, in the present invention, the conductor pattern in the region of the print circuit board where at least the through hole is formed is preferably formed with a width larger than the width of the land portion.

According to the present invention, since the conductor pattern in the region where at least a through hole is formed is formed with a width larger than the width of the land portion, while a sectional area required for the conductor pattern is ensured, as many through holes provided for radiation as possible may be installed. It is only necessary that a width larger than the width of the land portion is ensured for the conductor pattern, and it may be a constant width substantially equal to the width of the land portion or it may be expanded to a constant width larger than the width of the land portion. Also, as long as the width larger than the width of the land portion is ensured, the width does not have to be constant but may be expanded / reduced as necessary.

Since the present invention is configured as above, heat from the point-like light source of a planar illumination device using the point-like light source can be radiated more efficiently and as a result, while higher and more uniform brightness of the planar illumination device is accommodated, thinning of the apparatus can be promoted.

### Brief Description of the Drawings

Fig. 1 is a sectional view of a flexible print circuit board on which a point-like light source is surface-mounted in a planar illumination device according to an embodiment of the present invention;
Fig. 2 is a sectional view when a heat conductive resin having fluidity is used in the flexible print circuit board shown in Fig. 1;
Figs. 3 are single piece view of the flexible print circuit board shown in Fig. 1, in which Fig. 3A is a front side view and Fig. 3B is a back side view;
Fig. 4 is a view illustrating a state where the point-like light source is surface-mounted on the flexible print circuit board shown in Fig. 3A; and
Fig. 5 is a perspective view illustrating a conventional planar illumination device.

### Reference Numerals

- 1: Planar illumination device
- 2: Light guide plate
- 3: Point-like light source
- 5a: Radiator plate
- 10: Flexible print circuit board
- 10F: Front side face
- 10R: Back side face
- 12: Land portion
- 14: Conductor pattern
- 16: Through hole
- 18: High heat-conductive resin
- 20: Conductor pattern
- 26: Heat conductive resin having fluidity
- A: Region

### Best Mode for Carrying Out the Invention

Embodiments of the present invention will be described below based on the attached drawings. Here, the same portions or portions corresponding to the prior art are indicated by the same reference numerals and detailed description will be omitted.

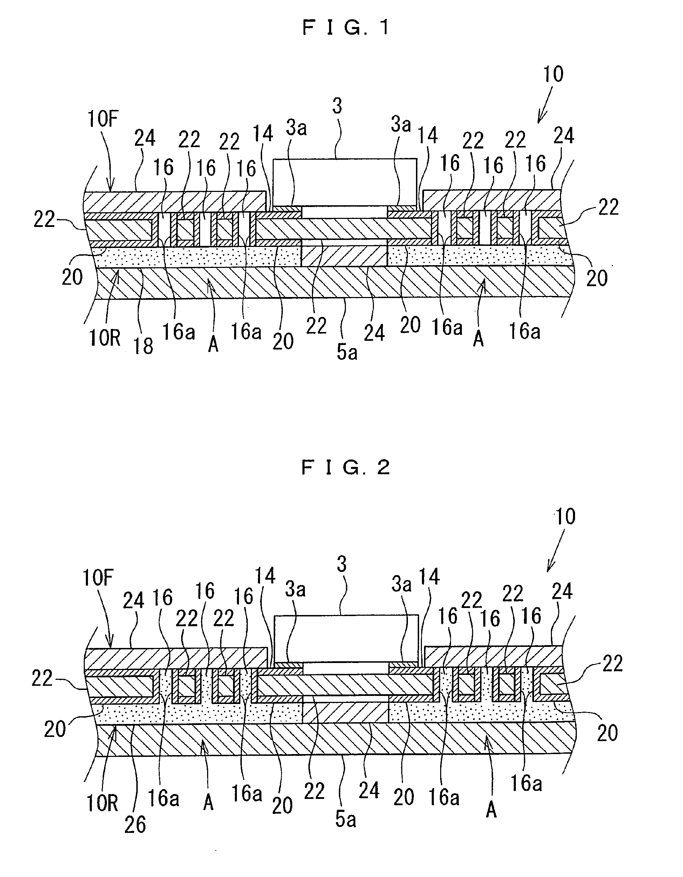

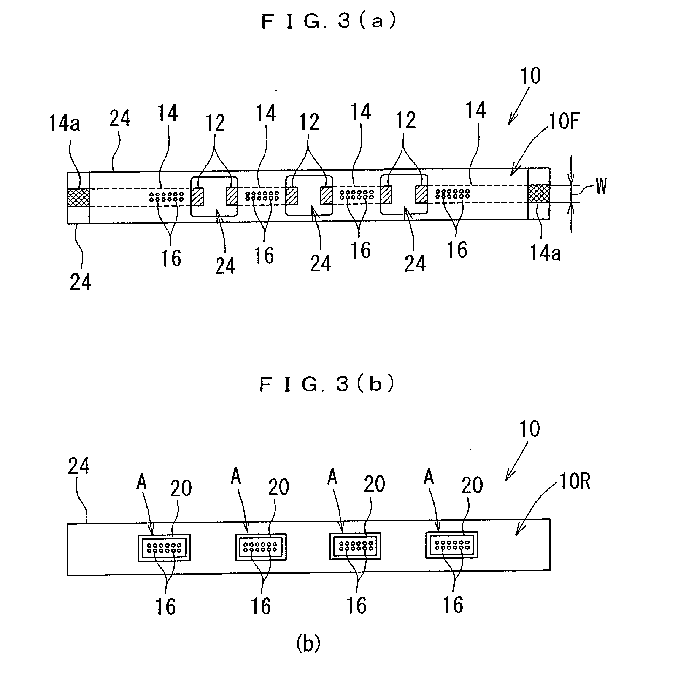

Fig. 1 shows a flexible print circuit board (FPC) 10 on which a large-current type LED is surface-mounted as the point-like light source 3 in a section of a planar illumination device according to the embodiment of the present invention. The FPC 10 has the same basic configuration such as outline and thickness as the FPC 4 shown in Fig. 5. Specifically, as shown in Figs. 3A and 3B, a conductor pattern 14 continuing to a land portion 12 where an electrode terminal 3a of the point-like light source 3 is mounted on a front side face 10F is formed. This conductor pattern 14 is formed with the same constant width as a width W of the land portion 12. In order to effectively achieve self-alignment in the biaxial direction in a plane of the FPC when the point-like light source 3 is mounted, the width of the conductor pattern needs to be made narrower than the width of the land portion, but because of a reason, which will be described later, the width of the conductor pattern may be formed with substantially the same constant width as the width W of the land portion 12. A portion indicated by the reference character 14a in Fig. 3A is a land portion for connection to the outside. To the conductor pattern 14 continuing to the land portion 12, a through hole 16 is formed. On a wall surface of the through hole 16, a plating film 16a is formed. The sectional shape of the through hole 16 is preferably circular, when considering workability, but the shape is not necessarily limited to that. For formation of the through hole 16 and the plating film 16a, a process for producing a double-sided type FPC can be fully or partially used.

A region A of a back side face 10R of the FPC 10 where at least the through hole 16 is formed is bonded to a radiator plate 5a made of metal through a high heat-conductive resin 18 as shown in Fig. 1. The high heat-conductive resin 18 has electric insulation properties, and a silicon resin material or a high heat-conductive resin material in which a nonconductive heat conductive filler such as alumina, aluminum nitride, silicon carbide or the like is added can be used.

In the region A on the back side face 10R of the FPC 10 where at least the through hole 16 is formed, a conductive pattern 20 continuing to the plating film 16a applied on the through hole 16 is formed. Both the conductive patterns 14, 20 are formed on the surface of a flexible base film 22 made of polyimide or the like and moreover, covered by a flexible cover film 24 such as polyimide so as to cover the conductive patterns 14, 20.

In an example shown in Fig. 1, the high heat-conductive resin 18 is molded in the tape state. The tape-state high heat-conductive resin 18 is in a solid form when being applied between the back side face 10R of the FPC 10 and the radiator plate 5a, and it is excellent in workability. However, by using a high heat-conductive resin 26 having fluidity at least when being applied between the back side face 10R of the FPC 10 and the radiator plate 5a instead of the tape-state high heat-conductive resin 18, as shown in Fig. 2, the heat-conductive resin can be filled in the whole or a part within the through hole 16. As the high heat-conductive resin 26 having fluidity, a resin material of a type having considerable fluidity and not requiring a drying / solidifying process such as silicon compound, adhesives, gel-state resins and the like can be cited. In this case, since the surface of the through hole 16 is covered by the cover film 24, the high heat-conductive resin 26 does not protrude to the front side face 10F of the FPC 10, and since the high heat-conductive resin 26 is held between the base film 22 and the cover film 24 and brought into a sealed state, there is a merit that the high heat-conductive resin 18 does not have to be dried and solidified.

Fig. 4 shows a state where the point-like light source 3 is mounted on the front side face 10F of the FPC 10 shown in Fig. 3A.

Though detailed description will be omitted, the planar illumination device according to this embodiment of the present invention has the same basic configuration having a light guide plate, a point-like light source arranged on a side end face of the light guide plate, and a flexible print circuit board in which the point-like light source is mounted on the front side face as the conventional planar illumination device (See Fig. 5).

According to the embodiment of the present invention configured as above, the following working effects can be obtained. First, a radiation path is constituted through which heat generated from the point-like light source 3 is transmitted to the radiator plate 5a made of metal through the electrode terminal 3a of the point-like light source 3, the land portion 12 on the front side face 10F of the FPC 10, the through hole 16 of the conductive pattern 14, and the high heat-conductive resins 18, 26. Therefore, a radiation path for efficient radiation from the conductor pattern 14 of the FPC 10 to the radiator plate 5a made of metal is extended, and a direct radiation area is also sufficiently ensured. Particularly, even if a large-current type LED is used for the point-like light source 3, a sufficient radiation effect can be obtained. Also, since freedom of wiring pattern of the FPC 10 and freedom of outline are not different from a conventional FPC at all, demand for thinning of a planar illumination device can be sufficiently satisfied.

Also, since the conductor pattern 20 continuing to the plating film 16a applied in the through hole 16 is formed in the region A on the back side face 10R of the FPC 10 where at least the through hole 16 is formed, a radiation path is constituted through which the heat generated from the point-like light source 3 is transmitted to the radiator plate 5a made of metal through the electrode terminal 3a of the point-like light source, the land portion 12 on the front side face 10F of the FPC 10, the plating film 16a in the through hole 16 of the conductor pattern 14, the conductor pattern 20 on the back side face 10R of the FPC 10, and the high heat-conductive resins 18, 26. Therefore, the radiation path for efficient radiation from the conductor pattern 14 of the FPC 10 to the radiator plate 5a made of metal is extended, and the above working effect can be obtained efficiently.

The conductor pattern 20 on the back side face 10R of the FPC 10 has a main purpose of improving the radiation performance, and it is sufficient if the pattern is provided only on the region A where the through hole 16 is formed, but the pattern may be extended as necessary similarly to the conductor pattern 14 on the front side face 10F.

If the high heat-conductive resin 26 has fluidity at least when being applied between the back side face 10R of the FPC 10 and the radiator plate 5a and is filled within the through hole 16, a radiation path is constituted through which the heat radiated from the point-like light source 3 is transmitted to the radiator plate 5a made of metal through the electrode terminal 3a of the point-like light source 3, the land portion 12 on the front side face 10F of the FPC 10, the plating film 16a and the high heat-conductive resin 26 in the through hole 16 of the conductor pattern 14, and the high heat-conductive resin 26 as well as the high heat-conductive resin 26 applied between the back side face 10R of the FPC 10 and the radiator plate 5a. Therefore, the radiation path for efficient radiation from the conductor pattern 14 of the FPC 10 to the radiator plate 5a made of metal is further extended and the above working effect can be obtained further greatly.

Moreover, since the conductor patterns 14, 20 of the region A in the FPC 10 where at least the through hole 16 is formed are formed with the width larger than the width W of the land portion 12, a sectional area required for the conductor patterns 14, 20 is ensured, while as many through holes 16 as possible for radiation can be installed. Specifically, since the width W of the conductor patterns 14, 20 is relatively large, heat resistance of the conductor pattern is small and the heat generated from the point-like light source 3 is easily transmitted to the conductor pattern 14 side through the land portion 12. Also, since the width W of the conductor patterns 14, 20 is relatively large, the installation place for the through hole 16 can be ensured wide, and as many through holes 16 as possible can be installed.

It is only necessary that the conductor patterns 14, 20 are ensured to have the width larger than the width W of the land portion 12, and thus, the width may be expanded from a constant width substantially equal to the width W of the land portion 12 to a constant width larger than the width W of the land portion. Also, as long as the width larger than the width W of the land portion 12 is ensured, the width does not have to be constant but may be expanded / contracted as necessary, or the width other than the region A where the through hole 16 is formed may be narrowed.

Moreover, from the following reason, the width W of the land portion 12 of the FPC 10 is preferably equal to the width of the electrode terminal 3a of the point-like light source 3. That is, the land portion 12 has a structure that the cover film 24 is removed and the conductor is exposed, but since the width W of the land proton 12 is substantially equal to the width of the electrode terminal 3a and also the conductor pattern 14 continuing to the land portion 12 has the width substantially equal to (or larger than) the width W of the land portion 12, mechanical strength of the conductor pattern 14 is drastically improved, and even if some impact force is applied to the FPC 10 during assembling of the planar illumination device or after assembling into the device, no disconnection occurs in the land portion 12.

Moreover, when the point-like light source 3 is mounted on the FPC 10 by a reflow process, the point-like light source 3 can be positioned to a predetermined position on the FPC 10 with high accuracy owing to the self-alignment effect.

When the conductor pattern 14 continuing to the land portion 12 has the width substantially equal to (or larger than) the width W of the land portion 12, it is worried that the self-alignment effect is weakened in the extension direction of the conductor pattern 14 (direction from the land portion 12 to a land portion 14a for outside connection in the example in Fig. 3). However, even if the position of the point-like light source 3 is displaced in the extension direction of the conductor pattern 14, a plurality of same-shaped prisms extending in the thickness direction of the light guide plate are arranged on an incoming-light face 2a (Fig. 5) of the light guide plate 2 in the extension direction of the conductor pattern 14 so as to constitute diffusing means, the incidence rate of light from the point-like light source 3 to the light guide plate 2 is scarcely changed. Therefore, even if the self-alignment effect in the extension direction of the conductor pattern 14 is weakened, characteristics as the planar illumination device are not affected.

It should be understood that the point-like light source 3 mounted on the FPC 10 can be applied not only to a case where its outgoing face is the face on the side opposite the one where the electrode terminal 3a of the point-like light source 3 is provided as shown in the example in Fig. 5 (that is, the FPC 4 in Fig. 5 is totally replaced by the FPC 10 according to the embodiment of the present invention) but also to a case where a face crossing the face on which the electrode terminal 3a of the point-like light source 3 is provided is an outgoing face.

Also, in the embodiment of the present invention, a case where the radiation path from the point-like light source 3 to the radiator plate 5a made of metal is formed on the FPC 10 is described as an example, but it should be understood that the radiation path can be similarly applied to a case where another print circuit board other than FPC is used.

## Claims

1. A planar illumination device comprising a light guide plate, a point-like light source arranged on the side end face of the light guide plate, and a print circuit board, the front side face of which is provided with the point-like light source,
**characterized in that**:
a through hole is formed on a conductor pattern continuing to a land portion in the print circuit board where the point-like light source is mounted; and
a region on the back side face of the print circuit board where at least the through hole is formed is bonded to a radiator plate through a high heat-conductive resin.

2. The planar illumination device according to claim 1, wherein on the region of the back side face of the print circuit board where at least the through hole is formed, a conductor pattern continuing to a plating film applied on the through hole is fabricated.

3. The planar illumination device according to claim 1 or 2, wherein the high heat-conductive resin is filled in the through hole while retaining fluidity in application at least between the back side face of the print circuit board and the radiator plate.

4. The planar illumination device according to any one of claims 1 to 3, wherein a conductor pattern in a region where at least the through hole is formed in the print circuit board is fabricated with a width larger than the width of the land portion.
